# DEMANDE DE BREVET EUROPEEN

(11) **EP 4 692 811 A1**
(43) Date de publication de la demande: **11.02.2026**
(21) Numéro de dépôt: 25194283.5
(22) Date de dépôt: 06.08.2025
(51) Int. Cl.: G01R 15/18, G01R 19/00, G01R 21/06, G01R 31/50

(54) **MODULE DE MESURE DE COURANT ÉLECTRIQUE**

(30) Priorité: 07.08.2024 FR 2408750
(71) Demandeur: SCHNEIDER ELECTRIC INDUSTRIES SAS, 92500 Rueil-Malmaison (FR)
(72) Inventeur: KOCH, Juliette, 38100 GRENOBLE (FR); BUFFAT, Sebastien, 38210 TULLINS (FR)
(74) Mandataire: Lavoix

(57) **Abrégé**

La présente invention concerne un module de mesure (1) de courant électrique destiné à mesurer un courant électrique traversant un conducteur électrique (3). Le module de mesure comprend au moins un élément ferromagnétique (23) et deux portions rectilignes (6) d'un enroulement principal (7) de fil (9) conducteur d'électricité identiques. Chaque portion rectiligne comporte un support (11) comprenant un corps (13) de forme linéique et au moins une extrémité (15). Le module de mesure est configuré pour prendre une configuration fermée dans laquelle l'au moins un élément ferromagnétique recouvre l'extrémité distincte de chaque portion rectiligne de l'enroulement principal, et une configuration ouverte dans laquelle l'au moins un élément ferromagnétique est séparé des portions rectilignes.

## Description

La présente invention concerne un module de mesure de courant électrique.

L'invention se situe dans le domaine des dispositifs de mesure de grandeurs électriques.

Les installations électriques, par exemple les réseaux locaux de distribution d'électricité, adaptés pour la distribution d'électricité dans un bâtiment, comportent en général plusieurs charges et, le cas échéant, plusieurs sources, connectées par des conducteurs électriques.

Il existe un besoin d'assurer la supervision, le bon fonctionnement et la sécurité de telles installations électriques et, pour ce faire, il est utile de fournir des moyens de mesures de grandeurs électriques permettant de caractériser les signaux électriques circulant dans les conducteurs électriques, par des mesures de grandeurs électriques.

En particulier, la mesure de courant assure la sécurité en permettant de déclencher l'actionnement de dispositifs de protection comme par exemple des disjoncteurs.

Ainsi, la mise en œuvre de dispositifs de mesure de courant est un problème récurrent dans le domaine de la supervision des installations électriques.

Dans le domaine des dispositifs de mesure de courant, en particulier pour la mesure de courant alternatif ou d'impulsions de courant, on connaît des dispositifs utilisant un enroulement de fil conducteur hélicoïdal, également appelé bobinage, dits « capteurs de Rogowski ». L'enroulement est de préférence de forme circulaire, formant un anneau à l'intérieur duquel est positionné le conducteur électrique traversé par le courant électrique à mesurer. La tension induite dans l'enroulement est proportionnelle au taux de changement, en d'autres termes à la dérivée temporelle, du courant circulant dans le conducteur. La forme circulaire de l'enroulement, avec des spires équidistantes, présente les meilleures propriétés d'un point de vue théorique, mais est difficile à réaliser en pratique.

Dans des variantes, le capteur de courant est formé à partir de plusieurs enroulement linéaires, disposés par exemple en carré et délimitant un espace central de passage du conducteur électrique. Cependant, dans un tel agencement il est difficile de garantir l'immunité du capteur à des sources de courant autres que le conducteur électrique dont on cherche à mesurer le courant. Classiquement, on place, dans les angles d'un tel capteur de courant, des spires supplémentaires pour capter le flux dans les angles.

Il existe des capteurs de Rogowski ouvrants, comportant des enroulements sur une armature souple, ce qui permet d'insérer plus facilement le conducteur électrique de manière centrée entre les enroulements du capteur, sans avoir à débrancher le conducteur électrique. Cela présente l'avantage de faciliter et de gagner du temps lors la mise en place de tels capteurs.

JP 2010 256141 A, JP 2011 089883 A, US 2014/111190 A1, US 2017/108539 A1, WO 2013/166428 A1, US 2011/279207 A1 présentent de tels capteurs.

Cependant, les capteurs de ce type connus sont peu compacts, leur encombrement ne permettant pas leur intégration dans de petits tableaux électriques.

Le but de l'invention est alors de remédier à ces inconvénients en fournissant un module de mesure de courant électrique ouvrant, compact performant et robuste, tout en étant facile à fabriquer.

A cet effet, l'invention a pour objet un module de mesure de courant électrique destiné à mesurer un courant électrique traversant un conducteur électrique, le module de mesure comprenant :
- deux portions rectilignes d'un enroulement principal de fil conducteur d'électricité identiques, chaque portion rectiligne comportant un support comprenant un corps de forme linéique et au moins une extrémité,
- au moins un élément ferromagnétique, l'au moins un élément ferromagnétique comprenant deux logements présentant une forme complémentaire à une forme des extrémités.

Selon l'invention, le module de mesure est configuré pour prendre :
- une configuration fermée dans laquelle l'au moins un élément ferromagnétique recouvre l'extrémité distincte de chaque portion rectiligne de l'enroulement principal, les extrémités étant logées et centrées dans les logements, et
- une configuration ouverte dans laquelle l'au moins un élément ferromagnétique est séparé des portions rectilignes.

Selon l'invention, chacun des logements est formé par une portion d'extrémité de l'au moins un élément ferromagnétique qui définit au moins un entrefer débouchant à l'extérieur du logement à travers une paroi périphérique du logement.

Grâce à l'invention, notamment grâce aux deux portions rectilignes de l'enroulement principal de fil conducteur et aux élèments ferromagnétiques, le module de mesure est ouvrant et simple à fabriquer. De plus, la présence deportions rectilignes identiques assure une bonne robustesse et une bonne performance au module de mesure.

Suivant d'autres aspects avantageux de l'invention, le module de mesure de courant électrique comprend une ou plusieurs des caractéristiques suivantes, prises isolément ou suivant toutes les combinaisons techniquement possibles :
- Les portions rectilignes de l'enroulement principal présentent des densités linéiques de fil conducteur d'électricité identiques et constantes sur leur longueur respective.
- Pour chaque portion rectiligne, un commencement de l'enroulement de fil conducteur et une fin de l'enroulement de fil conducteur sont positionnés à l'au moins une extrémité.
- Pour chaque portion rectiligne, une dimension transversale maximale de l'au moins une extrémité est supérieure à une dimension transversale maximale du corps.
- Les portions rectilignes sont réalisées en circuit imprimé.
- L'au moins un élément ferromagnétique est réalisé par pliage d'une plaque de matériau ferromagnétique.
- La plaque comprend une partie rectiligne centrale et deux paires de languettes s'étendant à des extrémités de la partie rectiligne, chaque paire de languettes formant un des logements une fois la plaque pliée.
- Le module de mesure comprend au moins une plaque additionnelle d'élément ferromagnétique fixée sur l'au moins un élément ferromagnétique.
- L'au moins un élément ferromagnétique est réalisé par usinage.
- L'au moins un élément ferromagnétique est réalisé dans un matériau ferromagnétique dont la perméabilité magnétique relative est supérieure ou égale à 10000.
- Le module de mesure comprend deux éléments ferromagnétiques.
- Le module de mesure comprend un unique élément ferromagnétique.

L'invention apparaîtra plus clairement à la lecture de la description qui va suivre, donnée uniquement à titre d'exemple non limitatif, et faite en référence aux dessins dans lesquels :
[Fig. 1] La figure 1 est une vue en perspective d'un module de mesure selon un premier mode de réalisation de l'invention et d'un conducteur électrique associé,
[Fig. 2] La figure 2 est une vue en perspective éclatée du module de mesure de la figure 1,
[Fig. 3] La figure 3 est une vue en perspective d'un enroulement principal de fil conducteur appartenant au module de mesure de la figure 1,
[Fig. 4] La figure 4 est une vue en plan d'un élément ferromagnétique appartenant au module de mesure de la figure 1, avant d'être mis en forme,
[Fig. 5] La figure 5 est une vue en perspective, analogue à la figure 1 mais sans conducteur électrique associé, d'un module de mesure selon un deuxième mode de réalisation de l'invention,
[Fig. 6] La figure 6 est une vue en perspective, analogue à la figure 5, d'un module de mesure selon un troisième mode de réalisation de l'invention,
[Fig. 7] La figure 7 est une vue en perspective, analogue à la figure 1 mais sans conducteur électrique associé, d'un module de mesure selon un quatrième mode de réalisation de l'invention, et
[Fig. 8] La figure 8 est une vue en perspective, analogue à la figure 1 mais sans conducteur électrique associé, d'un module de mesure selon un cinquième mode de réalisation de l'invention.

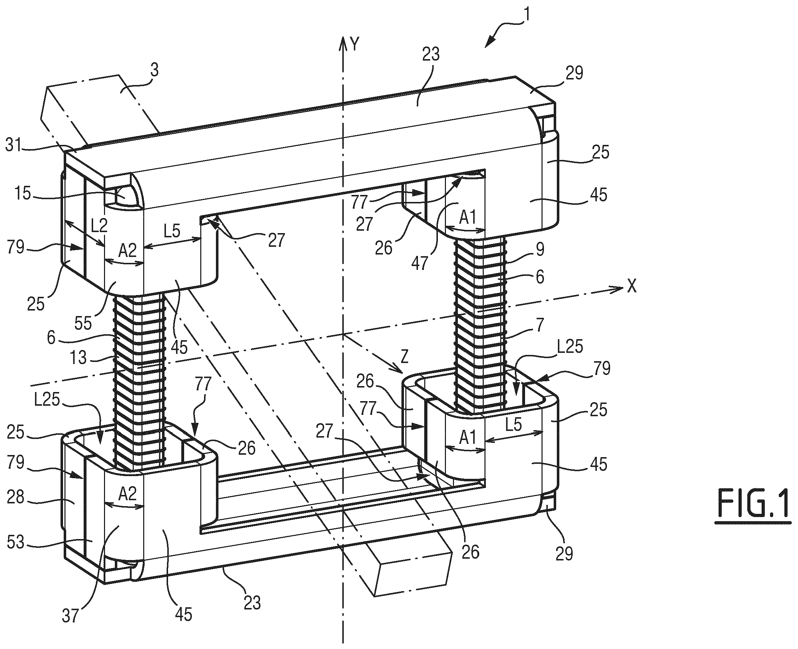

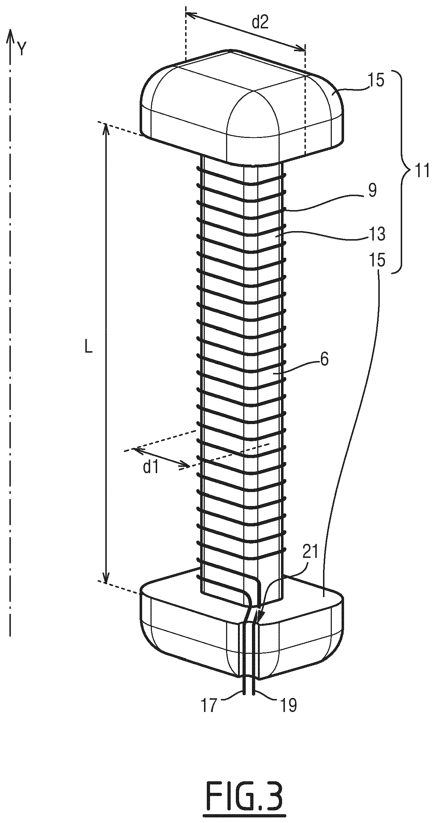

Un module de mesure 1 de courant électrique selon un premier mode de réalisation est décrit aux figures 1 à 5.

Le module de mesure 1 de courant destiné à réaliser en continu une mesure d'un courant électrique traversant un conducteur électrique 3.

Le conducteur électrique 3 fait partie d'une installation électrique, non représentée, dans laquelle le module de mesure 1 peut être positionné pour réaliser la mesure de courant.

Le module de mesure 1 est un capteur de courant inductif comportant un enroulement principal 7 de fil 9 conducteur d'électricité, également appelé bobinage principal.

Dans cet exemple, l'enroulement principal 7 comprend deux portions rectilignes 6 distinctes et indépendantes l'une de l'autre. Les deux portions rectilignes 6 sont identiques l'une de l'autre. Chaque portion rectiligne 6 comporte un support 11 de forme linéique. Chaque support 11 comprend un corps 13 et au moins une extrémité 15, dans cet exemple, le support comprend deux extrémités 15 disposées de part et d'autre du corps 13.

Chaque corps 13 est de forme linéique et s'étend parallèlement à un axe longitudinal Y défini par le module de mesure 1. Chaque corps 13, présente une section perpendiculaire à l'axe Y qui est constante, par exemple rectangulaire. On note d1 une dimension transversale maximale de la section du corps 13.

Les extrémités 15 sont, par exemple, de forme rectangulaire. On note d2 une dimension transversale maximale des extrémités 15.

Avantageusement, la dimension transversale maximale d2 des extrémités 15 est strictement supérieure à la dimension transversale maximale d1 de la section du corps 13.

L'enroulement principal 7 est réalisé par enroulement hélicoïdal d'un fil 9 autour de chaque support 11. En particulier, le fil 9 est, au moins, enroulé autour du corps 13 sur une longueur L mesurée entre les deux extrémités 15 à partir d'un commencement 17 de l'enroulement de fil 9 jusqu'à une fin 19 de l'enroulement du fil 9. Dans cet exemple, le commencement 17 et la fin 19 de l'enroulement sont, avantageusement, positionnés sur une même extrémité 15 du support 11.

Le fil 9 est par exemple un fil de cuivre, le support 11 étant en matériau synthétique, notamment en matériau plastique, par exemple en polymère à cristaux liquides (ou LCP).

Avantageusement, pour chaque portion rectiligne 6, le commencement 17 et la fin 19 de l'enroulement sont positionnés d'un côté de la même extrémité 15.

Avantageusement, une extrémité 15 de chaque portion rectiligne 6 comprend une première fente 21 ménagée de manière que le commencement 17 et la fin 19 de l'enroulement circulent et soient coincés dans la première fente 21 assurant ainsi le maintien en place de l'enroulement de fil 9 sur le support 11.

Avantageusement, les portions rectilignes 6 présentent des densités linéiques de fil 9 identiques et constantes sur leur longueur L respective, les densités linéiques étant comprises entre 40 spires par millimètre et 80 spires par millimètre.

Le module de mesure 1 comporte en outre au moins un élément ferromagnétique 23. Dans cet exemple, le module de mesure 1 comprend deux éléments ferromagnétiques 23.

On note XYZ un repère orthogonal associé au module de mesure 1 est assemblé, dont l'axe des abscisses est parallèle à une direction longitudinale des éléments ferromagnétiques 23, l'axe des ordonnées parallèle à une direction longitudinale des portions rectilignes 6 et l'axe des hauteurs parallèle à une direction de passage du conducteur électrique 3 à travers le module de mesure 1.

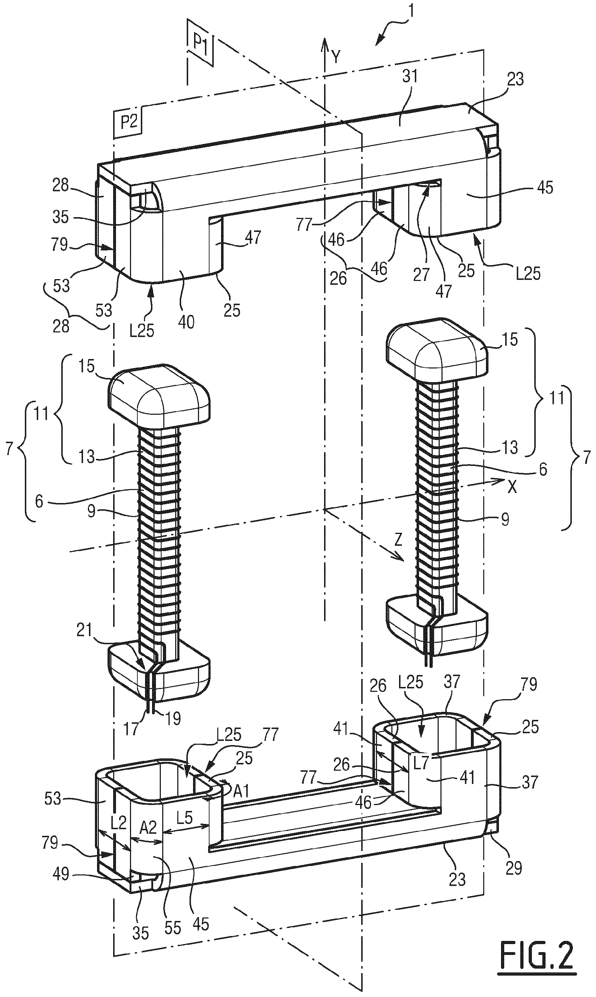

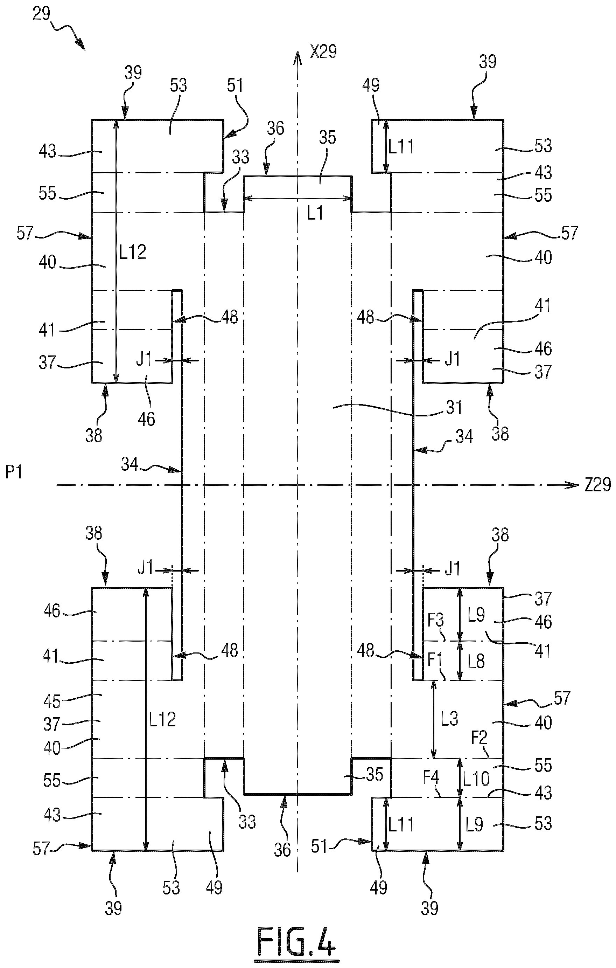

Les éléments ferromagnétiques 23 s'étendent transversalement au conducteur électrique 3, parallèlement à l'axe des abscisses X qui est perpendiculaire à l'axe Y. Les éléments ferromagnétiques 23 sont symétriques par rapport à un premier plan de symétrie P1 normal à l'axe transversal X et visible aux figures 2 et 4.

Chaque élément ferromagnétique 23 comprend deux portions d'extrémité 25 qui définissent chacune un logement L25. Chaque logement L25 s'étend parallèlement à l'axe longitudinal Y lorsque le module de mesure 2 est assemblé.

Avantageusement, chaque logement L25 présente une forme complémentaire à la forme des extrémités 15.

On note 26 une paroi périphérique intérieure d'une portion d'extrémité 25 tournée vers l'autre portion d'extrémité 25 d'un même élément ferromagnétique 23. Avantageusement, chaque portion d'extrémité 25 comprend, sur sa paroi intérieure 26, une deuxième fente 27. La deuxième fente 27 s'étend perpendiculairement aux axes X et Y lorsque le module de mesure 1 est assemblé. La deuxième fente 27 traverse la paroi intérieure 26 et débouche à l'extérieur du logement L25, en reliant le logement L25 à l'extérieur.

Pour chaque élément ferromagnétique 23, les deuxièmes fentes 27 sont en vis-à-vis l'une de l'autre. En d'autres termes la paroi intérieure 26 correspond à la paroi d'un logement L25 normale à l'axe transversal X et positionnée à la plus petite distance d'une paroi normale à l'axe transversal X de l'autre logement L25 de l'élément ferromagnétique 23.

On note 28 une paroi périphérique extérieure d'une portion d'extrémité 25, tournée à l'opposé de l'autre portion d'extrémité 25 d'un même élément ferromagnétique 23, la paroi extérieur 28 étant la deuxième paroi de la portion d'extrémité 25 normale à l'axe X.

Avantageusement, les éléments ferromagnétiques 23 sont réalisés avec des matériaux ferromagnétiques dont la perméabilité magnétique relative est supérieure ou égale à 10000. Par perméabilité magnétique relative d'un matériau, on entend le rapport de sa perméabilité magnétique sur la perméabilité magnétique du vide. Par exemple, les éléments ferromagnétiques 23 sont réalisés en acier, plus précisément dans un alliage fer-nickel ou fer-silicium, ces matériaux ayant une perméabilité magnétique importante.

Avantageusement, chaque élément ferromagnétique 23 est réalisé par pliage d'une plaque 29 représentée dépliée à la figure 4.

La plaque 29 comprend une partie rectiligne 31 s'étendant suivant un axe transversal X29 parallèle à l'axe X en configuration pliée et montée de l'élément ferromagnétique 23 dans le module de mesure 1 de l'élément ferromagnétique 23. La partie rectiligne 31 comprend deux bords longitudinaux 33 s'étendant perpendiculairement à l'axe transversal X29 et deux bords transversaux 34 identiques s'étendant parallèlement à l'axe transversal X29.

La plaque 29 comprend également, au niveau de chaque bord longitudinal 33, une excroissance 35 s'étendant parallèlement à l'axe transversal X29 au-delà du bord longitudinal adjacent 33 et comprenant un bord central 36.

Chaque bord central 36 est parallèle aux bords longitudinaux 33 et centré sur l'axe transversal X29. Une longueur L1 des bords centraux 36 est égale à une largeur L2 de la paroi extérieure 28.

La plaque 29 comprend également deux paires de languettes 37 identiques s'étendant aux extrémités de la partie rectiligne 31. Plus précisément les languettes 37 s'étendent dans le prolongement des quatre coins de la partie rectiligne 31.

Les quatre languettes 37 sont identiques et s'étendent parallèlement à l'axe transversal X29 entre un bord intérieur 38 et un bord extérieur 39.

La plaque 29 est symétrique par rapport à l'axe transversal X29 et symétrique par rapport à un axe de symétrie Z29 perpendiculaire à l'axe de transversal X29. En configuration pliée et montée de l'élément ferromagnétique 23 dans le module de mesure 1, l'axe Z29 est parallèle à l'axe Z.

Chaque languette 37 comprend une partie centrale 40, une partie intérieure 41 et une partie extérieure 43. Les parties intérieure 41 et extérieure 43 s'étendent parallèlement à l'axe transversal X29 de chaque côté de la partie centrale 40.

La partie centrale 40 est délimitée par deux lignes de pliage F1 et F2 perpendiculaires à l'axe transversal X29. La ligne de pliage F1 sépare la partie centrale 40 de la partie intérieure 41 et la ligne de pliage F2 sépare la partie centrale 40 de la partie extérieure 43.

La partie centrale 40 forme, lorsque la languette est pliée, une paroi médiane 45 parallèle à l'axe transversal X29 d'une portion d'extrémité 25, la paroi médiane 45 reliant la paroi intérieure 26 à la paroi extérieure 28. Les lignes de pliage F1 et F2 sont espacées d'une longueur L3 égale à une longueur L5 des parois médianes 45.

La partie intérieure 41 est délimitée par la ligne de pliage F1 et le bord intérieur 38. La partie intérieure 41 comprend également une ligne de pliage F3 perpendiculaire à l'axe transversal X29. Le bord intérieur 38 et la ligne de pliage F3 sont espacés d'une longueur L6 égale à la moitié d'une longueur L7 de la paroi intérieure 26. Les lignes de pliage F1 et F3 sont espacées d'une longueur L8 égale à une longueur d'arc A1 des coins intérieurs 47 reliant une des parois médianes 45 à la paroi intérieure 26 du logement L25.

La partie intérieure 41 forme, lorsque la languette 37 est pliée, la moitié 46 de paroi intérieure 26 du logement L25 et un des coins intérieurs 47 du logement L25.

On dénote 48 un bord intérieur inférieur de la partie intérieure 41, le bord intérieur inférieur 48 étant le bord de partie intérieure 41 à la plus petite distance d'un des bords transversaux 34.

La plaque 29 définit, pour chaque languette 37, un jeu J1 d'épaisseur non nulle entre le bord intérieur inférieur 48 et le bord transversal 34 le plus proche. Le jeu J1 forme la seconde fente 27 lorsque les languettes 37 sont pliées pour former les logements L25.

La partie extérieure 43 est délimitée par la ligne de pliage F2 et le bord extérieur 39. La partie extérieure 43 comprend également une ligne de pliage F4 perpendiculaire à l'axe transversal X29. Le bord extérieur 39 et la ligne de pliage F4 sont espacés d'une longueur L9 égale à la moitié de la longueur L2 de la paroi extérieure 28. Les lignes de pliage F2 et F4 sont espacées d'une longueur L10 égale à une longueur d'arc A2 des coins extérieurs 55 reliant une des parois médianes 45 à la paroi extérieure 28 du logement L25.

La partie extérieure 43 comprend un prolongement 49 qui s'étend perpendiculairement à l'axe transversal X29 en direction de l'axe transversal X29. Le prolongement forme un bord extérieur inférieur 51. Une longueur L11 du bord extérieur inférieur 51 est égale à la moitié de la longueur L1 des bords centraux 36.

Lorsque la languette 37 est pliée, la partie extérieure 43, forme une moitié 53 de la paroi extérieure 28 du logement L25 et un des coins extérieurs 55.

On note 57 un bord supérieur d'une languette 37, le bord supérieur 57 étant le bord parallèle à l'axe transversal X29 à la plus grande distance des bords transversaux 34. Le bord supérieur 57 est également un bord commun à la partie centrale 40, à la partie intérieure 41 et à la partie extérieure 43. Une longueur L12 du bord supérieur 57 est égale à la somme des longueurs L3, L6, L8, L9 et L10. En d'autres termes la longueur L1 est égale à la somme de la longueur L5 des parois médianes 45, de la moitié de la longueur L1, de la moitié de la longueur L7, de la longueur d'arc A1 des coins intérieurs 47 et de la longueur d'arc A2 des coins extérieurs 55.

Lorsque deux languettes 37 symétriques par rapport à l'axe transversal X29 sont pliées pour former un logement L25, les bords intérieurs 38 sont mis en regard l'un de l'autre pour que les parties intérieures 41 forment la paroi périphérique intérieure 26 et les bords extérieurs 39 sont mis en regard l'un de l'autre pour que les parties extérieures 43 forment la paroi périphérique extérieure 28. Les bords extérieurs inférieurs 51 sont alors en contact avec le bord central 36.

Dans la configuration pliée des languettes, les bords intérieurs 38 ne sont pas en contact et définissent entre eux un entrefer interne 77 en forme de fente rectiligne parallèle à l'axe Y, qui traverse la paroi périphérique interne 26 dans son épaisseur. De façon comparable, dans cette configuration, les bords extérieurs 39 ne sont pas en contact et définissent entre eux un entrefer externe 79 en forme de fente rectiligne parallèle à l'axe Y, qui traverse la paroi périphérique externe 28 dans son épaisseur.

Chaque élément ferromagnétique 23 définit ainsi deux entrefers internes 77 et deux entrefers externes 79.

Les entrefers 77 et 79 coupent respectivement en deux les parois périphériques intérieure 26 et extérieure 28. En particuliers, les logements L25 débouchent vers l'extérieur à travers les parois périphériques 26 et 28, via les entrefers 77 et 79.

Les entrefers 77 et 79 permettent d'éviter la formation de courant induit parasite au sein des logements L25. Les entrefers 77 et 79 améliorent donc la performance du module de mesure 1.Selon une variante non représentée de l'invention, un seul entrefer 77 ou 79 est prévu au niveau de chaque logement L25, soit sur sa paroi périphérique intérieure 26, soit sur sa paroi périphérique extérieure 28.

En variante, les entrefers 77 et 79 ne sont pas parallèles à l'axe Y, mais inclinés par rapport à cet axe. Ils peuvent également être courbes, par exemple en forme de S ou de W.

Le module de mesure 1 définit une configuration fermée et une configuration ouverte.

Dans la configuration fermée, chaque élément ferromagnétique 23 recouvre par une portion d'extrémité 25 chaque extrémité 15 distincte de chaque portion rectiligne 6. En d'autres termes en configuration fermée, une extrémité 15 de chaque portion rectiligne 6 est logée dans un des logements L25 d'un des éléments ferromagnétiques 23 et l'autre extrémité 15 est logée dans un des logements L25 de l'autre élément ferromagnétique 23. En position fermé, le module de mesure 1 est symétrique par rapport à un deuxième plan de symétrie P2 comprenant les axes X et Y.

Le module de mesure 1 ainsi formé est un capteur dit de Rogowski. Le module de mesure 1 utilise le principe de Rogowski pour mesurer le courant du conducteur électrique 3. En d'autres termes, le champ magnétique induit par le conducteur électrique 3 au travers du module de mesure 1 se propage à travers les éléments ferromagnétiques 23 et les portions rectilignes 6 de l'enroulement principal 7. La mesure de la tension au commencement 17 et à la fin 19 des portions rectilignes 6 permet de connaitre le courant traversant le conducteur électrique.

Dans la configuration ouverte, au moins un des éléments ferromagnétiques 23 est séparé des enroulements principaux.

Le module de mesure 1 est, ainsi, agencé en plusieurs parties, de manière à permettre une ouverture et une fermeture ultérieure, et par conséquent pour faciliter la mise en place du module de mesure 1 autour du conducteur électrique 3.

En d'autres termes, le module de mesure 1 est un capteur ouvrant formé de plusieurs parties séparables 7 et 23, permettant l'ouverture et la fermeture du capteur autour du conducteur électrique 3.

Les densités linéiques constantes et identiques des portions rectilignes 6 permettent de préserver les performances du module de mesure 1 lors de l'ouverture et de la fermeture puisque le gain du module de mesure 1 est proportionnel à la densité linéique et non à la distance séparant les éléments ferromagnétiques 23.

De plus, le recouvrement des extrémités 15 des portions rectilignes 6 par les éléments ferromagnétiques 23 en configuration fermée, permet de négliger les défauts de bobinage aux extrémités 15 des portions rectilignes 6 puisque le flux induit par les extrémités 15 est dans les éléments ferromagnétiques et n'interfère pas dans la prise de mesure.

La présence des deux éléments ferromagnétiques 23 encadrant les portions rectilignes 6 assure les bonnes performances du module de mesure 1 et participe à la robustesse du module de mesure 1 en limitant la diaphonie.

Avantageusement la complémentarité de forme des extrémités 15 et des logements L25 assure un centrage mécanique des éléments ferromagnétiques 23 par rapport aux portions rectilignes 6 de manière à assurer un gain constant du capteur lors des ouvertures et des fermetures du capteur. Ainsi, sa manipulation par un opérateur est plus aisée.

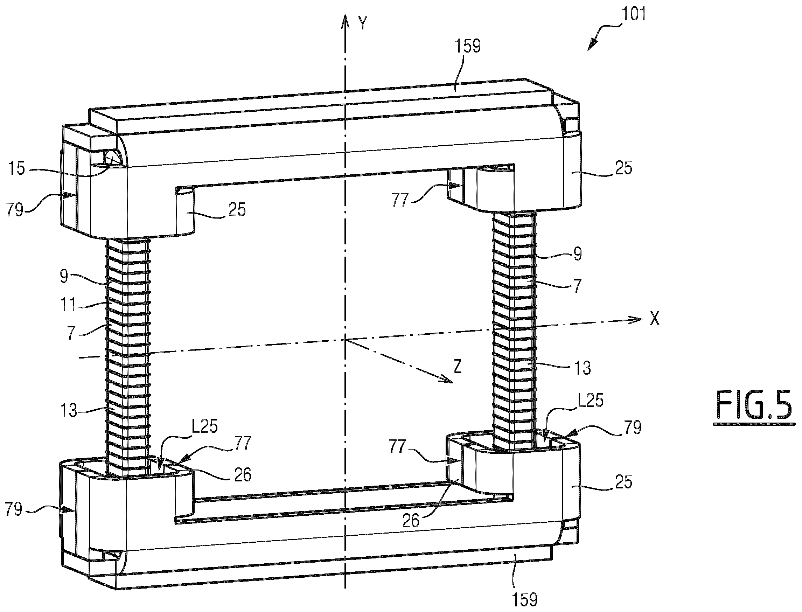

Si un élément est référencé sur l'une des figures 5 à 8 sans être mentionné dans la description, il correspond à l'élément portant la même référence dans le premier mode de réalisation.

Un module de mesure 101 selon un deuxième mode de réalisation est représenté à la figure 5. Le module de mesure 101 est identique au module de mesure 1 du premier mode de réalisation, à l'exception des caractéristiques décrites ci-dessous. Les signes de référence du module de mesure 101 correspondent à ceux du module de mesure 1 lorsque l'élément de référence est le même. Les signes de référence sont augmentés de 100 par rapport à ceux du premier mode de réalisation, lorsqu'ils désignent des éléments modifiés dans le module de mesure 101.

Le module de mesure 101 comprend au moins une plaque additionnelle 159. Dans cet exemple le module de mesure 101 comprend deux plaques additionnelles 159. Chaque plaque additionnelle 159 est rectangulaire et a des dimensions identiques à la partie rectiligne 31 des éléments ferromagnétiques 23. Chaque plaque additionnelle 159 est fixée sur un des éléments ferromagnétiques 23 sur la partie rectiligne 31.

Les plaques additionnelles 159 permettent de repousser la limite de saturation magnétique des éléments ferromagnétiques 23 et ainsi d'éviter une saturation du matériau ferromagnétique.

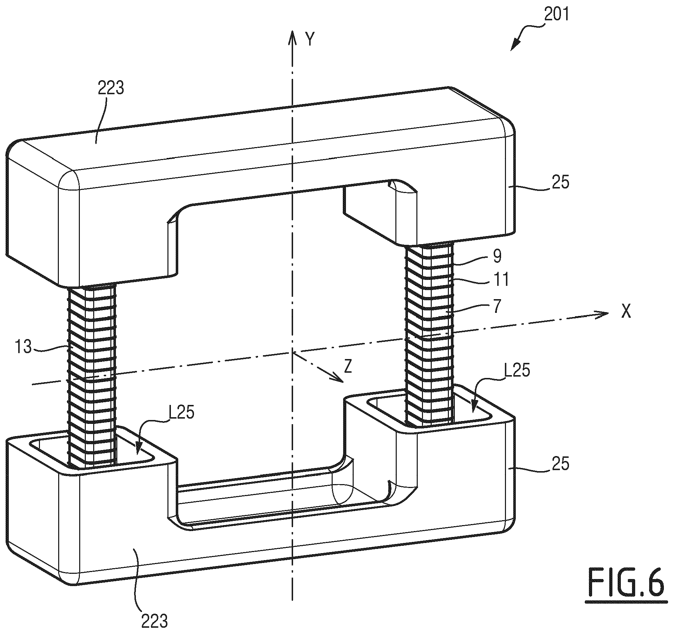

Un module de mesure 201 selon un troisième mode de réalisation est représenté à la figure 6. Le module de mesure 201 est identique au module de mesure 1 du premier mode de réalisation, à l'exception des caractéristiques décrites ci-dessous. Les signes de référence du module de mesure 201 correspondent à ceux du module de mesure 1 lorsque l'élément de référence est le même. Les signes de référence sont augmentés de 200 par rapport à ceux du premier mode de réalisation, lorsqu'ils désignent des éléments modifiés dans le module de mesure 201.

Les éléments ferromagnétiques 223 sont réalisés par usinage. Les éléments ferromagnétiques 223 sont réalisés à la chaine par une machine-outil, non représentée, sur une ligne de production automatisée à partir d'un bloc d'élément ferromagnétique. La fabrication des éléments ferromagnétiques 223 est alors facilitée et peu couteuse.

Dans une variante non représentée de ce mode de réalisation, un ou des entrefers peuvent être usinés dans les parois des logements L25, ces entrefers étant comparables aux entrefers 77 et 79 du premier mode de réalisation.

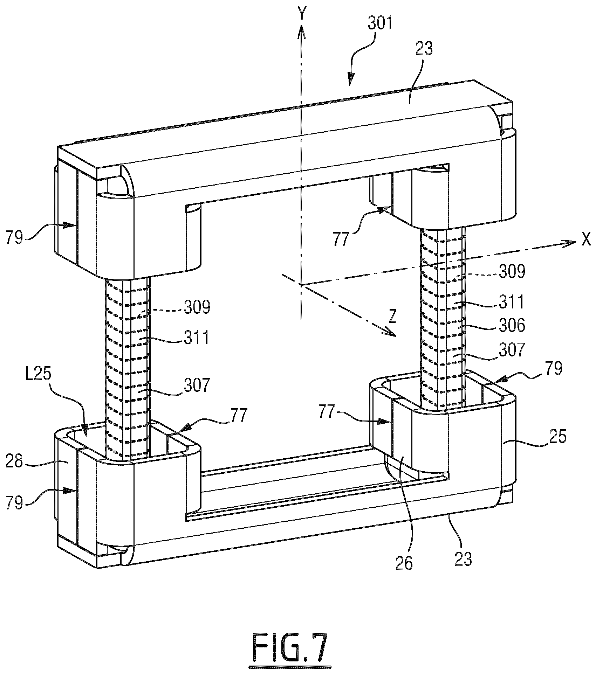

Un module de mesure 301 selon un quatrième mode de réalisation est représenté à la figure 7. Le module de mesure 301 est identique au module de mesure 1 du premier mode de réalisation, à l'exception des caractéristiques décrites ci-dessous. Les signes de référence du module de mesure 301 correspondent à ceux du module de mesure 1 lorsque l'élément de référence est le même. Les signes de référence sont augmentés de 300 par rapport à ceux du premier mode de réalisation, lorsqu'ils désignent des éléments modifiés dans le module de mesure 301.

Les portions rectilignes 306 du module de mesure 301 sont réalisées sous la forme d'un circuit imprimé. Autrement dit, chaque portion rectiligne 306 comprend un support 311 dans lequel est directement imprimé un fil 309 électrique.

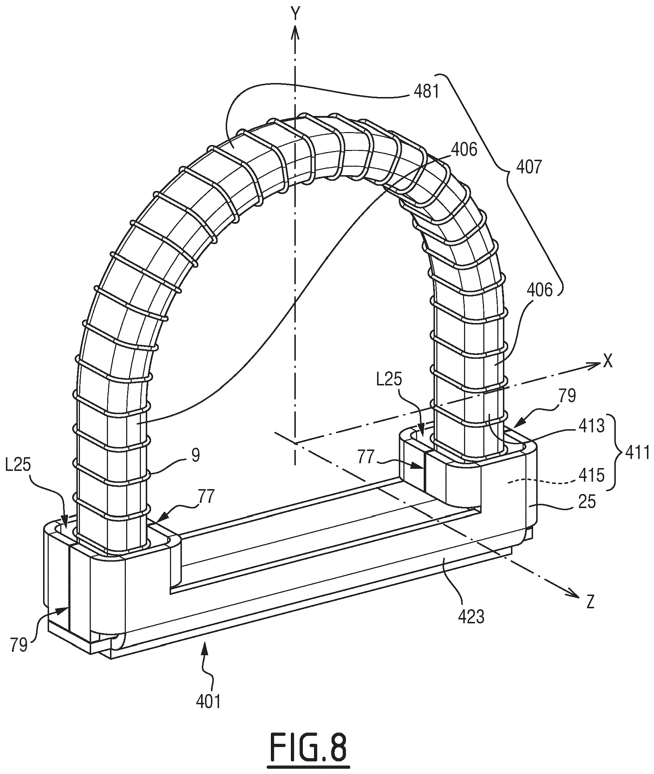

Un module de mesure 401 selon un cinquième mode de réalisation est représenté à la figure 8. Le module de mesure 401 est identique au module de mesure 1 du premier mode de réalisation, à l'exception des caractéristiques décrites ci-dessous. Les signes de référence du module de mesure 401 correspondent à ceux du module de mesure 1 lorsque l'élément de référence est le même. Les signes de référence sont augmentés de 400 par rapport à ceux du premier mode de réalisation, lorsqu'ils désignent des éléments modifiés dans le module de mesure 401.

Le module de mesure 401 comprends un unique élément ferromagnétique 423.

Le module de mesure 401 comprends un enroulement principal 407. L'enroulement principal 407 a une forme de « U » dans la figure 8 et comporte une portion centrale arrondie 481 et deux portions rectilignes 406 s'étendant de manière symétrique dans le prolongement de la portion centrale arrondie 481. Ainsi, les deux portions rectilignes 406 sont fabriquées d'une seule et même pièce. Chaque portion rectiligne 406 comporte un support 411 comprenant un corps 413 de forme linéique et une extrémité 415.

L'extrémité 15 de chaque portions rectiligne 406 est apte à être reçue dans un des logements L25 de l'élément ferromagnétique 423.

L'enroulement principal 407 est réalisé par enroulement hélicoïdal d'un fil 9 autour de la portion centrale arrondie 481 et des deux portions rectilignes 406.

Quel que soit le mode de réalisation, les entrefers 77 et 79 ne sont pas forcément centrés sur les parois 26 et 28. Ils ne sont pas forcément ménagés sur une paroi interne et sur une paroi externe de l'élément ferromagnétique 23, 223 ou 423.

Toute caractéristique décrite ci-avant pour un mode de réalisation ou une variante est applicable aux autres modes de réalisation et variantes décrits ci-avant, pour autant que cela est techniquement possible.

## Revendications

1. Module de mesure (1 ; 101 ; 201 ; 301 ; 401) de courant électrique destiné à mesurer un courant électrique traversant un conducteur électrique (3), le module de mesure (1 ; 101 ; 201 ; 301 ; 401) comprenant :
- deux portions rectilignes (6 ; 306 ; 406) d'un enroulement principal (7 ; 307 ; 407) de fil (9 ; 309) conducteur d'électricité identiques, chaque portion rectiligne (6; 306 ; 406) comportant un support (11 ;311 ;411) comprenant un corps (13 ; 413) de forme linéique et au moins une extrémité (15 ; 415),
- au moins un élément ferromagnétique (23; 223 ; 423), l'au moins un élément ferromagnétique (23; 223 ; 423) comprenant deux logements (L25) présentant une forme complémentaire à une forme des extrémités (15; 415),
le module de mesure (1 ; 101 ; 201 ; 301 ; 401) étant configuré pour prendre :
- une configuration fermée dans laquelle l'au moins un élément ferromagnétique (23; 223 ; 423) recouvre l'extrémité (15; 415) distincte de chaque portion rectiligne (6; 306 ; 406) de l'enroulement principal (7; 307 ; 407), les extrémités (15; 415) étant logées et centrées dans les logements (L25), et
- une configuration ouverte dans laquelle l'au moins un élément ferromagnétique (23; 223 ; 423) est séparé des portions rectilignes (6; 306 ; 406)
le module de mesure (1 ; 101 ; 201 ; 301 ; 401) étant **caractérisé en ce que** chacun des logements (L25) est formé par une portion d'extrémité (25) de l'au moins un élément ferromagnétique (23; 423) qui définit au moins un entrefer (77, 79) débouchant à l'extérieur du logement (L25) à travers une paroi périphérique (26, 28) du logement (L25).

2. Module de mesure (1; 101 ; 201 ; 301 ; 401) selon la revendication 1, dans lequel les portions rectilignes (6; 306 ; 406) de l'enroulement principal (7; 307 ; 407) présentent des densités linéiques de fil (9; 309) conducteur d'électricité identiques et constantes sur leur longueur respective.

3. Module de mesure (1; 101 ; 201 ; 301 ; 401) selon l'une quelconque des revendications précédentes, dans lequel, pour chaque portion rectiligne (6), un commencement (17) de l'enroulement de fil (9; 309) conducteur et une fin (19) de l'enroulement de fil (9; 309) conducteur sont positionnés à l'au moins une extrémité (15; 415).

4. Module de mesure (1; 101 ; 201 ; 301 ; 401) selon l'une quelconque des revendications précédentes, dans lequel, pour chaque portion rectiligne (6), une dimension transversale maximale (d2) de l'au moins une extrémité (15; 415) est supérieure à une dimension transversale maximale (d2) du corps (13; 413).

5. Module de mesure (301) selon l'une quelconque des revendications précédentes, dans lequel les portions rectilignes (306) sont réalisées en circuit imprimé.

6. Module de mesure (1; 101 ; 301 ; 401) selon l'une quelconque des revendications précédentes, dans lequel l'au moins un élément ferromagnétique (23; 223 ; 423) est réalisé par pliage d'une plaque (29) de matériau ferromagnétique.

7. Module de mesure (1; 101 ; 301 ; 401) selon la revendication précédente, dans laquelle la plaque (29) comprend une partie rectiligne (31) centrale et deux paires de languettes (37) s'étendant à des extrémités de la partie rectiligne (31), chaque paire de languettes (37) formant un des logements (L25) une fois la plaque pliée.

8. Module de mesure (101) selon l'une quelconque de revendications précédentes, comprenant au moins une plaque additionnelle (159) d'élément ferromagnétique fixée sur l'au moins un élément ferromagnétique (23; 223 ; 423).

9. Module de mesure (201) selon l'une quelconque des revendications 1 à 9, dans lequel l'au moins un élément ferromagnétique (223) est réalisé par usinage.

10. Module de mesure (1; 101 ; 201 ; 301 ; 401) selon l'une quelconque des revendications précédentes, dans lequel l'au moins un élément ferromagnétique (23 ; 223 ; 423) est réalisé dans un matériau ferromagnétique dont la perméabilité magnétique relative est supérieure ou égale à 10000.

11. Module de mesure (1; 101 ; 201 ; 301) selon l'une quelconque des revendications précédentes, comprenant deux éléments ferromagnétiques (23 ; 223).

12. Module de mesure (401) selon l'une quelconque des revendications 1 à 10, comprenant un unique élément ferromagnétique (423).
